Europäisches Patentamt

European Patent Office

Office européen des brevets

(11) Publication number: **0 287 749**
**A1**

# EUROPEAN PATENT APPLICATION

(21) Application number: 87810259.9

(51) Int. Cl.⁴: **H01L 39/12**

(22) Date of filing: 23.04.87

(43) Date of publication of application:
26.10.88 Bulletin 88/43

(84) Designated Contracting States:
AT BE CH DE ES FR GB GR IT LI LU NL SE

(71) Applicant: **International Business Machines Corporation**
**Old Orchard Road**
**Armonk, N.Y. 10504(US)**

(72) Inventor: **Bednorz, Johannes Georg, Dr.**
**Sonnenbergstrasse 47**
**CH-8134 Adliswil(CH)**
Inventor: **Mueller, Carl Alexander, Prof. Dr.**
**Haldenstrasse 54**
**CH-8908 Hedingen(CH)**

(74) Representative: **Rudack, Günter O., Dipl.-Ing.**
**IBM Corporation Säumerstrasse 4**
**CH-8803 Rüschlikon(CH)**

(54) **New layered copper oxide superconductor compounds.**

(57) The superconductive compounds are oxides of the general formula $RE_xAE_{x+2}Cu_{x+3}O_{7-y}$ , wherein RE is a rare earth metal or a rare earth-like metal, AE is a member of the group of alkaline earth metals or a combination of at least two members of that group, and wherein $x = 2, 3, 4$ and $y \leq 1$. The compounds have a perovskite-like structure with corner-sharing octahedral layers of copper oxide ($CuO_6$) being interlinked by two corner-sharing square-planar copper oxide ($CuO_4$) units.

EP 0 287 749 A1

## NEW LAYERED COPPER OXIDE SUPERCONDUCTOR COMPOUNDS

The invention relates to new superconductors, in particular to compounds containing layers of corner-sharing copper oxygen octahedra having superconductor properties below a relatively high transition temperature.

Superconductivity is usually defined as the complete loss of electrical resistance of a material at a well-defined temperature. It is known to occur in many materials: About a quarter of the elements and over 1000 alloys and components have been found to be superconductors. Superconductivity is considered a property of the metallic state of the material, in that all known superconductors are metallic under the conditions that cause them to superconduct. A few normally non-metallic materials, for example, become superconductive under very high pressure, the pressure converting them to metals before they become superconductors.

Superconductors are very attractive for the generation and energy-saving transport of electrical power over long distances, as materials for forming the coils of strong magnets for use in plasma and nuclear physics, in nuclear resonance medical diagnosis, and in connection with the magnetic levitation of fast trains. Power generation by thermonuclear fusion, for example, will require very large magnetic fields which can only be provided by superconducting magnets. Certainly, superconductors will also find application in computers and high-speed signal processing and data communication.

While the advantages of superconductors are quite obvious, the common disadvantage of all superconductive materials so far known has been their very low transition temperature (usually called the critical temperature $T_c$) which has until recently been around 23 degrees Kelvin. The use of superconductors at these temperatures requires liquid helium which is very expensive and not sufficiently abundent to justify industrial application.

To improve the situation, i.e., to raise the critical temperature $T_{c,}$, Bednorz and Müller have introduced compounds of the Ba-La-Cu-O system, metallic oxides, which exhibit a critical temperature $T_c$ of about 40 K (c.f. J.G. Bednorz and K.A. Müller, Possible High $T_c$ Superconductivity in the Ba-La-Cu-O System, Z. Phys. B - Condensed Matter 64, 189-193 (1986); J.G. Bednorz, M. Takashige and K.A. Müller, Susceptibility Measurements Support High - $T_c$ Superconductivity in the Ba-La-Cu-O System, Europhys. Lett., 3(3), 379-385 (1987); EP-A-...... Nr. 87100961.9).

These compounds consist of copper oxygen octahedra having corners at which oxygen atoms are located, and in between layers of LaO. The base formula of these compounds is $La_2CuO_4$ in which the lanthanum is partially substituted by alkali earth ions, such as $Ca^{2+}$, $Sr^{2+}$ or $Ba^{2+}$ The critical temperature of these substituted compounds is in the 40 K range, i.e., with these materials, cooling with liquid neon becomes possible.

The work of Bednorz and Müller has attracted the interest of numerous groups of scientists who all concentrate on compounds of the Ba-La-Cu-O system and their equivalents, i.e. those compounds which consist of a rare earth element partially substituted by an element of the alkaline earth group, and combined with a copper oxide, of the general formula $AE_xRE_{2-x}CuO_{4-y}$, where AE stands for the group of alkaline earth elements, and RE stands for the group of rare earth elements. Of course, also compounds of the AE-RE-Cu-O system not meeting the x:2-x:1 relation have been investigated.

As a result of all of these efforts, several new materials have been found which exhibit a critical temperature above the boiling point of nitrogen. One paper recently published is of particular interest in this connection: M.K. Wu et al., Superconductivity at 93 K in a New Mixed-Phase Y-Ba-Cu-O Compound System at Ambient Pressure, Phys. Rev. Lett. 58(9) (1987) pp. 908-910. Herein, the rare earth lanthanum, use of which was proposed by Bednorz and Müller in their first paper cited above, is replaced by its closest relative yttrium, a rare earth-like metal of the same IIIB group of the periodic table of elements as lanthanum.

The composition of the compound proposed in this reference has been determined to be the single-phase Y $Ba_2Cu_3O_7$ (cf. M.A. Beno et al., Structure of the Single Phase High Temperature Superconductor Y $Ba_2Cu_3O_7$, submitted in March 1987 to Appl. Phys. Lett.; J.J. Capponi et al., Structure of the 100K Superconductor $Ba_2Y$ $Cu_3O_7$ between 5 & 300 K by Neutron Powder Diffraction, submitted in March 1987 to Europhys. Lett.). This compound is reported to have a critical temperature above 90 K. i.e. cooling is considerably facilitated, not only because less energy is required, but also because liquid nitrogen can be used for cooling, and there is a virtually unlimited supply.

The x-ray and diffraction patterns so far published for this compound have been indexed on the basis of the perovskite lattice where, along a particular [100] direction, i.e. along the quasi-tetragonal c-axis of the crystal, a layer of oxygen atoms is missing. In addition, stoichiometry requires that still further oxygen atoms should be missing. The structure proposed by these references thus requires layers of copper atoms with five-fold coordination not otherwise known to exist in ordered layers in oxides. It is, hence, not clear whether these compounds are stable.

It is, therefore, an object of the present invention to propose new compositions for high-$T_c$ superconductors comprising layered copper oxide in which the copper coordination is by six and four oxygen atoms, these coordinations being generally known in inorganic chemistry.

The present invention proposes compounds having a layer-type structure of corner-sharing copper oxygen octahedra. This structure is in particular present in oxides of the general composition RE $AE_{1+x}Cu_{2+x}O_{7-y}$, wherein RE stands for rare earth metals, including rare earth-like metals, AE stands for the group of alkaline earth elements. In this general formula, x may take the values 2, 3 or 4. It is a characteristic of the present invention that in the compounds in question the stoichiometry is preserved at relative ratios of 1:3:4, 1:4:5, or 1:5:6, resulting in an octahedral and square-planar structure.

The oxygen content of the compounds in accordance with the present invention actually depends on the heat treatment the compounds undergo during fabrication. This is best described by y having a value of unity or slightly smaller.

For example, compounds that meet the description given above include lanthanum strontium copper oxide $LaSr_3Cu_4O_{7-y}$, yttrium barium copper oxide $Y\ Ba_3Cu_4O_{7-y}$, and scandium calcium copper oxide $Sc\ Ca_3Cu_4O_{7-y}$. Lanthanum is, of course, a rare earth metal. It may be replaced by any one, or a mixture, of the other rare earth metals, generally called the lanthanides, and comprising the elements with the atomic numbers from 58 through 71. Accordingly, neodym strontium copper oxide $Nd\ Sr_5Cu_6O_{7-y}$ also fits the description given above.

Yttrium and scandium are rare earth-like metals belonging to the same IIIB group of the periodic table of elements as lanthanum, and being chemically so similar to the 'genuine' rare earth elements, -associated with which they occur in nature-, that they are very hard to separate from those.

These compounds are all ceramic metal oxides having a perovskite-like structure. They can be produced by conventional synthesis methods such as solid-state reactions of the individual binary metal oxides, or by calcination of the respective mixed hydroxides, carbonates, nitrates, etc.; cf. A. Reller, Reversible Reduktions-und Reoxidationsprozesse des Typs $ABO_3 \leftrightarrows ABO_{3-x}$ an Perovskitischen Metalloxiden, Berichte Bunsenges. Phys. Chem. 90, 742-745 (1986). In order to obtain stable compounds, their production should preferably occur at a temperature below 950°C.

The compounds in accordance with the present invention consist of corner-sharing copper oxide

($CuO_6$) octahedral layers, the same as in $LaCuO_4$, interlinked by two or more corner-sharing square-planar copper oxide $CuO_4$ units. Their diamagnetism was found to be larger than that of the known $Y\ Ba_2Cu_3O_{7-y}$ compound.

## Claims

1) Superconductor compounds of the RE $AE_{2+x}Cu_{3+x}O_{7-y}$ type, with RE standing for a rare earth metal or a rare earth-like metal, AE standing for an alkaline earth metal, and having a transition temperature above 90 K, characterized in that x = 2, 3, 4, such that the stoichiometric relations between the rare earth metal, or the rare earth-like metal (RE), the alkaline earth metal (AE) and copper are respectively 1:3:4, 1:4:5 or 1:5:6, that the copper coordination is by six and four oxygen atoms, and that the oxygen content (y le 1) is adjusted such that the resulting crystal structure has perovskite layers.

2) Compounds in accordance with claim 1, characterized in that they consist of corner-sharing copper oxide octahedral layers ($CuO_6$) interlinked by at least two corner-sharing square-planar units ($CuO_4$).

3) Compounds in accordance with claim 1, characterized in that the rare earth metal (RE) is lanthanum, with the structural formula being La $AE_3Cu_4O_{7-y}$.

4) Compounds in accordance with claim 1, characterized in that the rare earth metal (RE) is scandium, with the structural formula being Sc $AE_3Cu_4O_{7-y}$.

5) Compounds in accordance with claim 1, characterized in that the rare earth metal (RE) is yttrium, with the structural formula being Y $AE_3Cu_4O_{7-y}$.

6) Compounds in accordance with any one of claims 3 through 5, characterized in that the alkaline earth metal (AE) is barium, with the structural formula being RE $Ba_3Cu_4O_{7-y}$.

7) Compounds in accordance with any one of claims 3 through 5, characterized in that the alkaline earth metal (AE) is strontium, with the structural formula being RE $Sr_3Cu_4O_{7-y}$.

8) Compounds in accordance with any one of claims 3 through 5, characterized in that the alkaline earth metal (AE) is calcium, with the structural formula being RE $Ca_3Cu_4O_{7-y}$.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | PHYSICAL REVIEW LETTERS, vol. 58, no. 4, 26th January 1987, pages 408-410, The American Physical Society, New York, US; R.J. CAVA et al.: "Bulk superconductivity at 36 K in La1.8Sr0.2CuO4" * Page 408, the three first paragraphs * | 1-3,6,7 | H 01 L 39/12 |
| A | SCIENCE, vol. 236, 3rd April 1987, pages 73-75, Lancaster, US; J.G. BEDNORZ et al.: "Superconductivity in alkaline earth-substituted La2CuO4-y" * Whole document * | 1-3,6-8 | |
| D,A | PHYSICAL REVIEW LETTERS, vol. 58, no. 9, 2nd March 1987, pages 908-910, The American Physical Society, New York, US; M.K. WU et al.: "Superconductivity at 93 K in a new mixed-phase Y-Ba-Cu-O compound system at ambient pressure" * Whole document * | 1,3,5-7 | |

TECHNICAL FIELDS SEARCHED (Int. Cl.4)

H 01 L

The present search report has been drawn up for all claims

| Place of search | Date of completion of the search | Examiner |
|---|---|---|
| THE HAGUE | 18-12-1987 | BAILLET B.J.R. |

EPO FORM 1503 03.82 (P0401)